(19) **Europäisches Patentamt**

**European Patent Office**

**Office européen des brevets**

(11) **EP 1 085 659 B1**

(12) **FASCICULE DE BREVET EUROPEEN**

(45) Date de publication et mention
de la délivrance du brevet:
**17.05.2006 Bulletin 2006/20**

(51) Int Cl.:
*H03M 1/66* *(2006.01)*      *H03M 1/06* *(2006.01)*
*H03M 3/02* *(2006.01)*      *H03M 1/08* *(2006.01)*

(21) Numéro de dépôt: **00402559.9**

(22) Date de dépôt: **15.09.2000**

(54) **Convertisseur numérique-analogique en courant**

Digital-Analog-Wandler des Stromtyps

Current type digital to analogue converters

(84) Etats contractants désignés:
**AT BE CH CY DE DK ES FI FR GB GR IE IT LI LU MC NL PT SE**

(30) Priorité: **17.09.1999 FR 9911666**

(43) Date de publication de la demande:
**21.03.2001 Bulletin 2001/12**

(73) Titulaire: **Atmel Grenoble S.A.**
**38120 Saint Egreve (FR)**

(72) Inventeurs:
• **Masson, Thierry**
**94117 Arcueil Cedex (FR)**
• **Icord, Isabelle**
**94117 Arcueil Cedex (FR)**

(74) Mandataire: **Lucas, Laurent Jacques**
**Marks & Clerk France**
**31-33 Avenue Aristide Briand**
**94117 Arcueil Cedex (FR)**

(56) Documents cités:
• **DATABASE WPI Section EI, Week 199928 Derwent Publications Ltd., London, GB; Class U21, AN 1999-333785 XP002141205 -& JP 11 122112 A (YAMAHA CORP), 30 avril 1999 (1999-04-30)**
• **PATENT ABSTRACTS OF JAPAN vol. 017, no. 583 (E-1452), 22 octobre 1993 (1993-10-22) & JP 05 175850 A (MATSUSHITA ELECTRIC IND CO LTD), 13 juillet 1993 (1993-07-13)**

**EP 1 085 659 B1**

**Description**

La présente invention concerne un convertisseur numérique-analogique en courant. Elle s'applique notamment pour des convertisseurs numérique-analogique du type sigma-delta.

Le développement actuel des technologies tend à déplacer la frontière entre les techniques numériques et les techniques analogiques pour réduire au maximum la partie analogique. Cela a notamment pour but de simplifier l'architecture matérielle des systèmes en réalisant la plupart des fonctions en techniques numériques tout en permettant par ailleurs une réduction des coûts de fabrication. Une conséquence importante de cette évolution est l'énorme accroissement des contraintes reportées sur la partie de conversion analogique-numérique ou numérique-analogique, puisque le convertisseur se trouve alors en bout, ou presque, des chaînes de traitement. Les convertisseurs doivent donc répondre à des exigences de performances de plus en plus fortes.

En ce qui concerne les convertisseurs numérique-analogique, il en existe de plusieurs types. Parmi ces différents types, les convertisseurs du type sigma-delta ont un intérêt non négligeable puisqu'ils fonctionnent avec seulement un bit de conversion.

Dans les convertisseurs de type sigma-delta, le signal binaire codé sur N bit et échantillonné à une fréquence donnée Fs est converti par des moyens numériques en un signal à un bit suréchantillonné, c'est-à-dire échantillonné à une fréquence beaucoup plus élevée F's = MxFs. Ce signal est ensuite converti en un signal analogique grâce à un convertisseur numérique-analogique à un bit et un filtre passe-bas, placé en sortie du convertisseur.

Il est connu de réaliser ce type de convertisseur numérique-analogique de plusieurs façons. On peut réaliser un convertisseur en tension, c'est-à-dire que l'on envoie en sortie soit une tension positive, à un potentiel +Vref, soit une tension négative, à un potentiel -Vref, suivant l'état du signal binaire. Cette structure est cependant notamment limitée à environ 60dB de distorsion et est sensible aux instabilités de l'horloge de référence, ces instabilités étant généralement connues sous le terme de « jitter ». Ce jitter provoque notamment un bruit parasite en sortie du convertisseur.

On réalise aussi des convertisseurs en courant. Dans ce cas on envoie en sortie soit un courant positif, de valeur +Iref, soit un courant négatif, de valeur -Iref, suivant l'état du signal binaire. Ces convertisseurs permettent d'obtenir des performances en distorsion très élevées mais ils restent cependant sensibles au jitter de l'horloge.

Il est aussi connu de réaliser des convertisseurs à capacités commutées qui sont insensibles au jitter des horloges, mais ces derniers nécessitent des amplificateurs très rapides pour obtenir de bons niveaux de distorsion.

Une demande de brevet japonais JP -A-11122112 décrit un circuit qui fait varier l'amplitude du signal de sortie en fonction du jitter de l'horloge, utilisé pour les convertisseurs numérique-analogique.

Un but de l'invention est de permettre la réalisation d'un convertisseur garantissant un bon niveau de distorsion et insensible au jitter de l'horloge de référence.

A cet effet l'invention a pour objet un convertisseur numérique-analogique en courant tel que défini par la revendication 1.

Dans un deuxième mode de réalisation, le circuit de contrôle du temps d'établissement du courant de sortie comporte au moins deux tensions de référence, la capacité étant chargée puis déchargée entre ces deux tensions, le temps d'établissement du courant de sortie étant alors la somme du temps mis pour charger la capacité et du temps mis pour décharger la capacité. Un avantage de ce mode de réalisation est qu'il permet d'obtenir un bon rendement électrique.

Dans un troisième mode de réalisation on envoie directement le courant de charge et décharge de la capacité dans la charge de sortie du convertisseur, au moyen de commutateurs et de miroirs de courant. On utilise deux capacités que l'on charge et décharge. Pendant que l'une des capacités se charge, l'autre se décharge. Un avantage de ce mode de réalisation est qu'il permet de s'affranchir du bruit en courant du convertisseur.

D'autres caractéristiques et avantages de l'invention apparaîtront à la lecture de la description qui suit faite en référence aux dessins annexés qui représentent :

-    la figure 1, un synoptique d'un convertisseur numérique-analogique de type sigma-delta ;
-    la figure 2, un schéma synoptique d'un convertisseur
-    numérique-analogique en courant ;
-    la figure 3, un premier mode de réalisation possible d'un circuit de contrôle de la durée de charge du filtre de sortie dans un convertisseur selon l'invention ;
-    la figure 4, une illustration de signaux en jeu en fonction du temps t et en fonction du signal d'horloge dans le circuit précité ;
-    la figure 5, un deuxième mode de réalisation possible d'un circuit de contrôle de la durée de charge du filtre de sortie dans un convertisseur selon l'invention ;
-    la figure 6, une illustration de signaux en jeu en fonction du temps t et en fonction du signal d'horloge dans le circuit précité ;

- la figure 7, un autre mode de réalisation possible d'un convertisseur selon l'invention ;
- la figure 8, une illustration de signaux en jeu en fonction du temps t et en fonction du signal d'horloge dans le circuit précité, faisant notamment intervenir l'allure du courant de charge du filtre de sortie.

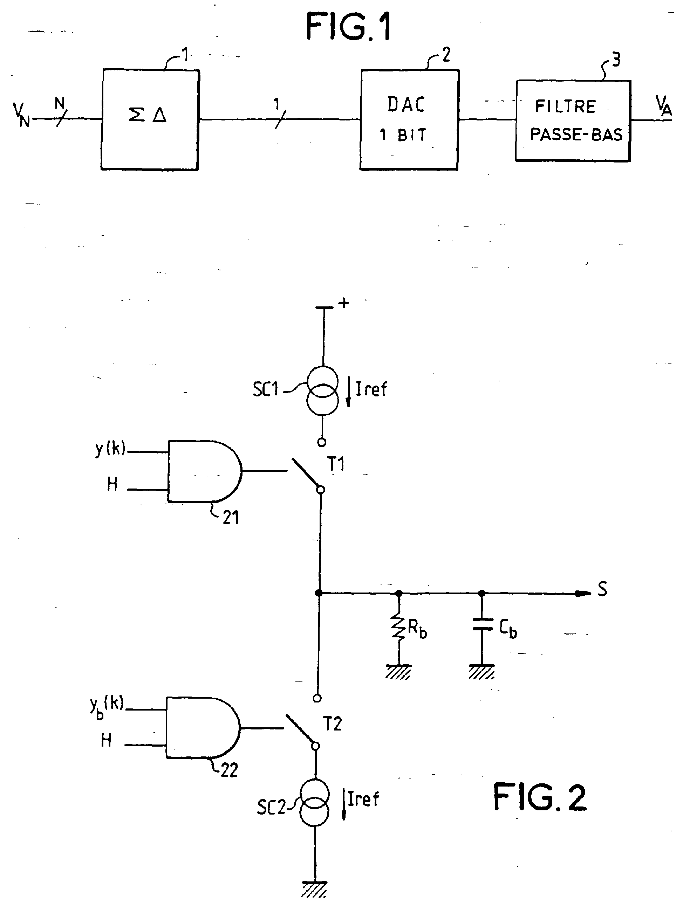

La figure 1 illustre par un synoptique une chaîne de conversion numérique-analogique du type sigma-delta. Cette chaîne permet la conversion d'un signal numérique $V_N$ codé sur N bits en un signal analogique $V_A$. Le signal $V_N$ est échantillonné en entrée d'un convertisseur sigma-delta 1 à une fréquence Fs. Ce dernier dont le mode de fonctionnement est bien connu par ailleurs délivre un signal codé sur un bit, suréchantillonné, c'est-à-dire que les bits successifs sortent du convertisseur sigma-delta à une cadence F's bien supérieur à la fréquence d'échantillonnage d'entrée Fs, F's = MxFs. Le signal de sortie du convertisseur sigma-delta est ensuite converti en un signal analogique par l'intermédiaire d'un convertisseur numérique-analogique 2 puis par un filtre passe-bas 3.

Le fonctionnement d'une telle chaîne de conversion peut être décrit succinctement. Le signal binaire $V_N$ parallèle codé sur N bits est donc transformé par le convertisseur sigma-delta 1 en un signal série véhiculé sur un bit. Lorsque la valeur du bit à l'entrée du convertisseur 2 est par exemple égale à 1, ce dernier délivre une tension +Vref, s'il fonctionne en tension, ou un courant +Iref s'il fonctionne en courant. Lorsque la valeur du bit est par exemple égale à 0, le convertisseur délivre une tension -Vref, ou -$I_{ref}$. Le filtre passe-bas 3 placé en sortie du convertisseur numérique-analogique 2 réalise une moyenne dans le temps des signaux ainsi fournis par le convertisseur. Cette moyenne constitue le résultat de la conversion numérique-analogique, c'est-à-dire le signal $V_A$ précité.

La figure 2 présente un schéma synoptique d'un convertisseur numérique-analogique en courant. Ce convertisseur reçoit en entrée un signal binaire codé sur un bit, ce signal est noté y(k). Ce signal est par exemple fourni en sortie d'un convertisseur sigma-delta, ou tout autre moyen de conversion d'un signal parallèle N bit en un signal série. A titre d'exemple, le signal y(k) est successivement les N bits y(0), ...y(k),.....y(N-1) du signal parallèle $V_N$ codé sur N bit parallèle et à convertir en valeur analogique.

Le convertisseur illustré par la figure 2 comporte une première source de courant SC1 fournissant un courant $I_{ref}$. Cette source est connectée en entrée à une première borne d'alimentation, par exemple positive. Elle est connectée en sortie sur un premier interrupteur T1, réalisé à base de transistor bipolaire ou de type MOS. La sortie de ce premier interrupteur est connectée à l'entrée d'un deuxième interrupteur T2, lui aussi à base de transistor bipolaire ou de type MOS. L'autre borne du deuxième interrupteur est connectée à une deuxième source de courant SC2 reliée par ailleurs à une deuxième borne d'alimentation de potentiel inférieur à celui de la première source SC1, par exemple le potentiel de masse. Le point de jonction des deux interrupteurs est relié à un filtre passe-bas, par exemple constitué d'une résistance $R_b$ et d'une capacité $C_b$ en parallèle. La sortie S de la chaîne de conversion est le point de jonction de la résistance et de la capacité, l'autre point de jonction de ces éléments étant par exemple le potentiel de masse. Le premier interrupteur est commandé par le signal y(k) précité. Il n'est pas commandé directement par ce signal, mais en combinaison avec un signal d'horloge H, les deux signaux étant combinés par un circuit 21 réalisant un « et » logique entre les deux signaux. Le deuxième interrupteur est commandé par le signal conjugué $y_b(k)$ du précédent, toujours en combinaison avec le signal d'horloge H, par l'intermédiaire d'un circuit logique 22 réalisant un « et » logique entre les deux signaux. Les sortie des circuits logiques 21, 22, éventuellement amplifiées, commandent alors les bases ou les grilles de transistors interrupteurs T1, T2 selon qu'ils sont bipolaires ou de type MOS.

Le fonctionnement du convertisseur est alors le suivant. Si le bit y(k) est égal à 1, un courant ou une tension se présente sur la base ou la grille du transistor T1 qui est commandé à l'ouverture lorsque le signal d'horloge H est établi. Le courant $I_{ref}$ fourni par la première source de courant SC1 passe dans filtre passe-bas $R_bC_b$ via le transistor T1. Dans le même temps, le bit $y_b(k)$ est à 0, le transistor T2 n'ayant pas de courant ou de tension de commande reste bloqué à la fermeture. Lorsque le bit y(k) est égal à 0, le fonctionnement est inversé. Le transistor T1 est bloqué à la fermeture et le transistor T2 est commandé à l'ouverture. Dans ce cas le courant $I_{ref}$ de la deuxième source de courant passe dans le filtre passe-bas via le transistor T2 lorsque le signal d'horloge H est établi. Vu du filtre le courant $I_{ref}$ est alors inversé, il présente donc une valeur -$I_{ref}$, au lieu de +$I_{ref}$ dans le cas précédent.

Un tel convertisseur en courant, comme un convertisseur en tension, subit les jitters de l'horloge H. Pour obtenir à la fois de bonnes performances de distorsion et d'insensibilité au jitter de l'horloge, l'invention utilise un convertisseur numérique-analogique en courant, pour obtenir un bon niveau de distorsion, et comporte des moyens de contrôle du temps pendant lequel on envoie le courant dans le filtre passe-bas, indépendamment de la largeur du signal d'horloge H, pour s'affranchir du jitter de cette horloge. Ce temps est contrôlé par la charge ou décharge d'une capacité avec un courant constant jusqu'à une tension de référence. Le temps est alors égal au temps mis pour décharger la capacité. Un dispositif de limitation dit de clamp bloque la tension de la capacité à la tension de référence.

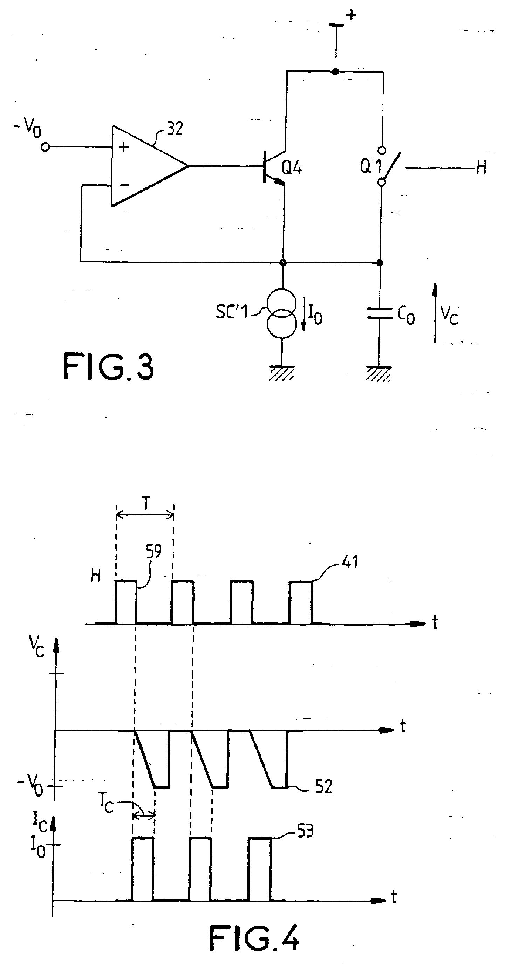

La figure 3 illustre un premier mode de réalisation possible d'un circuit de contrôle du temps d'injection de courant dans le filtre de sortie, c'est-à-dire en fait, un circuit de contrôle du temps d'établissement du courant de sortie du convertisseur -$I_{ref}$ ou +$I_{ref}$. Ce circuit comporte une capacité $C_0$ et un circuit de charge ou décharge de cette capacité. Il comporte donc un interrupteur Q1 commandé par le signal d'horloge H de telle sorte que Q1 soit passant lorsque le signal d'horloge est à 1 et bloqué lorsque le signal d'horloge est 0. Un circuit d'interface permet de commander l'interrupteur en courant, s'il s'agit d'un transistor bipolaire, ou en tension, s'il s'agit d'un transistor MOS, à partir du signal d'horloge H. L'interrupteur Q1 est connecté entre une borne d'alimentation positive et une borne d'une source de courant SC1' qui fournit un courant constant $I_0$, l'autre borne de cette source étant reliée à une autre borne d'alimentation, par exemple le potentiel de masse. Une capacité $C_0$, dite capacité de clamp, est câblée entre le point de jonction de l'interrupteur Q1 et de la source de courant SC1', et l'autre borne d'alimentation de la source, par exemple le potentiel de masse. Lorsque l'interrupteur Q1 est passant, c'est-à-dire en présence du signal d'horloge H, le courant $I_0$ passe dans l'interrupteur Q1. Lorsque ce dernier est bloqué, le courant $I_0$ charge la capacité $C_0$. La tension Vc aux bornes de cette dernière décroît alors à partir d'une valeur nulle comme l'illustre la figure 4.

La figure 4 illustre les différents signaux en jeu en fonction du temps t et en fonction du signal d'horloge H. Ce dernier est un signal binaire illustré par une courbe 41. Une deuxième courbe 52 représente la tension Vc aux bornes de la capacité $C_0$. Sur le front montant 59 du signal d'horloge, la capacité commence à se charger à courant constant $-I_0$, depuis la tension 0. Elle se charge ainsi jusqu'à ce que sa tension atteigne une valeur $-V_0$, dite tension de clamp.

Un circuit limite en effet la tension Vc à une valeur minimum $-V_0$, tension de référence. Ce circuit comporte un amplificateur opérationnel 32 dont l'entrée positive est reliée à un potentiel de valeur $-V_0$ et dont l'entrée négative est reliée à l'émetteur d'un transistor PNP Q4, cet émetteur étant relié au point de jonction de la source de courant, de la capacité $C_0$ et de l'interrupteur Q1. La base du transistor Q4 est commandée par la sortie de l'amplificateur opérationnel 32 et son collecteur est relié à la borne d'alimentation positive. Lorsque la tension Vc atteint la valeur dite de clamp $-V_0$, la sortie de l'amplificateur opérationnel délivre une tension positive qui commande le transistor Q4 à l'état passant, ce dernier étant bloqué auparavant. Le courant $I_0$ est alors dévié par Q4, la capacité reste alors chargée à la valeur de tension $-V_0$, ce qu'illustre une deuxième courbe 52 de la figure 4. Lorsque l'interrupteur Q1 redevient passant, la tension Vc redevient égale à la tension présente aux bornes de la source de courant SC1', c'est-à-dire sensiblement nulle.

Une troisième courbe 53 illustre le courant de charge $I_0$ de la capacité en fonction du temps t. La durée d'établissement de ce courant est parfaitement contrôlée par la durée de charge de la capacité $C_0$, illustrée par l'évolution de la tension entre 0 et -Vc. Cette durée est indépendante du jitter de l'horloge H et peut ainsi être utilisée pour commander les interrupteurs T1, T2 du convertisseur, tel que celui de la figure 2 par exemple. Pour cela on prévoit un circuit de mise en forme qui crée un signal logique dont la durée est égale au temps de charge de la capacité $C_0$. Ce signal commande alors les interrupteurs T1, T2 en combinaison des signaux $y(k)$ et $y_b(k)$ en remplacement du signal d'horloge lui-même H. D'autres moyens peuvent être prévus pour réaliser la largeur de courant de sortie du convertisseur $I_{ref}$ égale au temps de décharge de la capacité $C_0$.

L'exemple de réalisation d'un circuit de contrôle du temps d'établissement du courant de sortie du convertisseur fonctionne sur la base du temps de décharge de la capacité $C_0$. Il est bien sûr possible de réaliser un tel dispositif sur la base de la charge de la capacité $C_0$. D'un cas à l'autre, le signe du courant $I_0$ dans la capacité change.

Le temps $T_{on}$ pendant lequel les transistors T1, T2 sont commandés, qui est aussi le temps de décharge de la capacité $C_0$ est donné par la relation suivante :

$$T_{on} = \frac{C_0 V_0}{I_0} \qquad\qquad\qquad (1)$$

La charge injectée dans le filtre de sortie $R_b C_b$ pendant une période T d'horloge est :

$$Q = \frac{I_{ref} V_{ref} C_0}{I_0} \qquad\qquad\qquad (2)$$

Le rendement est relativement faible car la charge du filtre de sortie ne se fait que durant la durée Tc de charge de la capacité $C_0$ qui peut être faible devant la période T. Tc peut être par exemple de l'ordre de T/4.

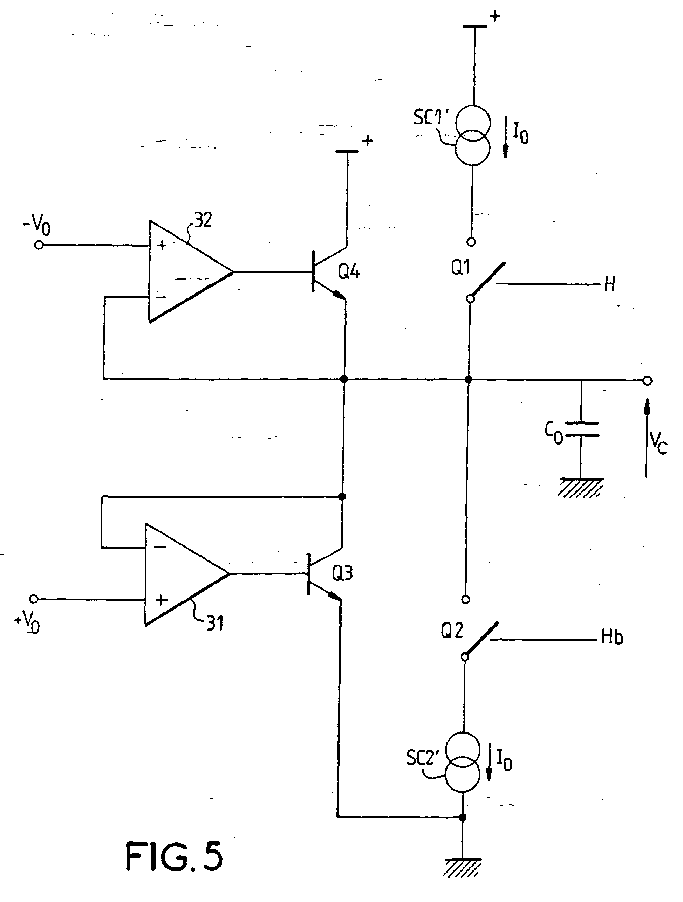

La figure 5 illustre un deuxième mode de réalisation possible d'un circuit de contrôle du temps d'injection du courant qui améliore le rendement. Dans ce mode de réalisation, on utilise deux tensions de référence et on charge et décharge la capacité entre ces deux tensions, dites encore de clamp. Le temps pendant lequel le convertisseur envoie le courant $I_{ref}$ en sortie, dans la charge, est alors la somme du temps mis pour charger la capacité et du temps mis pour décharger la capacité. Le courant $I_{ref}$ du convertisseur peut par ailleurs être divisé par deux par rapport au cas précédent, avec le même paquet de charge envoyé en sortie.

Le circuit comporte un circuit de charge et décharge de la capacité $C_0$ à deux tensions de référence. Il comporte donc en série une première source de courant SC1' connectée à une borne d'alimentation, un premier interrupteur Q1, un deuxième interrupteur Q2 et une deuxième source de courant SC2' reliée à une deuxième borne d'alimentation, par exemple le potentiel de masse. Les interrupteurs sont par exemple des transistors bipolaires ou des transistors de type MOS Les deux sources de courant délivrent un courant $I_0$. Le premier interrupteur Q1 est commandé par le signal d'horloge H et le deuxième interrupteur Q2 est commandé par le conjugué du signal d'horloge $H_b$. Une capacité $C_0$ est connectée entre le point de jonction des deux interrupteurs Q1, Q2. Le signal EN présent sur cette capacité $C_0$ remplace le signal H combiné aux bits y(k), $y_b$(k) en entrée du convertisseur tel qu'illustré par la figure 2.

Lorsque le signal d'horloge H est à 1, c'est-à-dire présent, La capacité $C_0$ se charge sous le courant constant $I_0$. En effet dans ce cas, le transistor Q1 est passant et le transistor Q2 est bloqué. La tension Vc aux bornes de la capacité $C_0$ croît donc linéairement. Lorsque le signal d'horloge H est à 0, le signal $H_b$ est à 1 et la capacité se décharge sous le courant constant $I_0$ via le deuxième interrupteur Q2. La tension Vc aux bornes de la capacité décroît alors linéairement. Deux circuits limitent cette tension Vc, l'un à une valeur maximum $V_0$ et l'autre à une valeur minimum -$V_0$. Le circuit de limitation à $V_0$ est par exemple constitué d'un amplificateur opérationnel 31 et d'un transistor bipolaire PNP Q3. L'entrée positive de l'amplificateur opérationnel 31 reçoit la tension $V_0$ et son entrée négative est reliée à l'émetteur du transistor Q3 lequel est par ailleurs relié au point de jonction des deux interrupteurs Q1, Q2. La sortie de l'amplificateur opérationnel commande la base du transistor Q3, dont la source est reliée à la deuxième borne d'alimentation, par exemple le potentiel de masse. Lorsque la tension Vc aux bornes du condensateur $C_0$, qui est aussi la tension présente sur l'entrée négative de l'amplificateur opérationnel atteint la valeur $V_0$ la sortie de l'amplificateur fournit un courant de base au transistor Q3 qui dérive alors le courant $I_0$ que continue à fournir la première source SC1' via l'interrupteur Q1 pendant le reste du temps où l'horloge H est à l'état 1. Le circuit de limitation à -$V_0$ est par exemple constitué d'un amplificateur opérationnel 32 et d'un transistor bipolaire NPN Q4. L'entrée positive de l'amplificateur opérationnel 32 reçoit la tension -$V_0$ et son entrée négative est reliée à l'émetteur du transistor Q4 lequel est par ailleurs relié au point de jonction des deux interrupteurs Q1, Q2. La sortie de l'amplificateur opérationnel commande la base du transistor Q4, dont le collecteur est relié à la première borne d'alimentation, positive. Lorsque la tension Vc aux bornes du condensateur $C_0$, qui est aussi la tension présente sur l'entrée négative de l'amplificateur opérationnel atteint la valeur -$V_0$ la sortie de l'amplificateur fournit un courant de base au transistor Q4 qui dérive alors le courant $I_0$ que continue à fournir la deuxième source SC2' via l'interrupteur Q2 pendant le reste du temps où l'horloge H est à l'état 0.

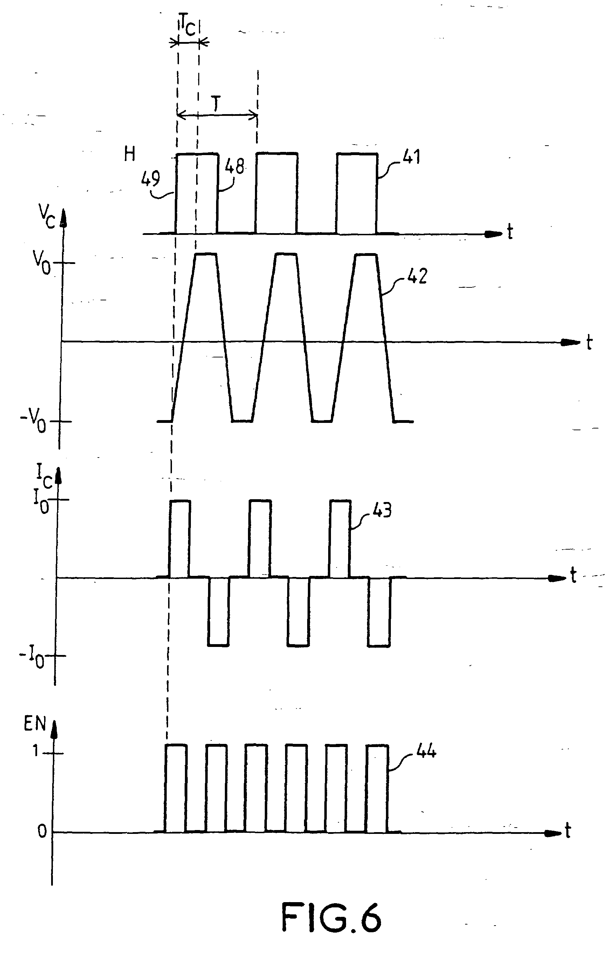

La figure 6 illustre les différents signaux en jeu en fonction du temps t et en fonction du signal d'horloge H. Ce dernier est un signal binaire illustré par une courbe 41. Une deuxième courbe 42 représente la tension Vc aux bornes de la capacité $C_0$. Sur le front montant 49 du signal d'horloge, la capacité commence à se charger à courant constant $I_0$, depuis la tension - $V_0$. Elle se charge jusqu'à ce que sa tension atteigne la valeur $V_0$. La tension Vc reste écrêté à $V_0$ pendant le reste du temps où le signal d'horloge est à l'état 1. Pendant le temps Tc de charge de la capacité, le courant de charge de cette dernière est $I_0$. Ce courant est nul pendant le reste du signal d'horloge H.

Sur le front descendant 48 du signal d'horloge H, ou sur le front montant de son signal conjugué $H_b$, la capacité commence à se décharger à courant constant $I_0$, depuis la tension $V_0$. Elle se décharge jusqu'à ce que sa tension atteigne la valeur -$V_0$. La tension Vc reste à -$V_0$ pendant le reste du temps où le signal d'horloge est à l'état 0. Pendant le temps Tc de charge de la capacité, le courant de charge de cette dernière est -$I_0$. Ce courant est nul une fois la valeur -$V_0$ atteinte. Une courbe 43 illustre l'allure du courant $I_0$.

Un signal binaire EN peut être créé par des moyens connus à partir de la tension Vc aux bornes de la capacité $C_0$. La largeur de ce signal est égale à la largeur du temps de montée de la tension Vc. En d'autres termes, à chaque montée de la tension Vc, le signal EN est égal à 1, et égal à 0 en dehors. C'est le signal EN qui est combiné aux bits y(k) et $y_b$(k) en entrée du convertisseur tel qu'illustré par exemple par la figure 2, à la place du signal d'horloge H. Eventuellement, le signal EN peut aussi être égal à 1 pendant la durée de la descente de la tension Vc.

La durée $T_{on}$ de charge de la capacité $C_0$ est donnée par la relation suivante :

$$T_{on} = \frac{2C_0 V_0}{I_0} \qquad\qquad\qquad (3)$$

Ce temps est aussi le temps pendant lequel les interrupteurs T1, T2 du convertisseur sont commandés. Il est indépendant du jitter de l'horloge H.

La charge Q injectée pendant une période T d'horloge est :

$$Q = \frac{2I_{ref} V_{ref} C_0}{I_0} \qquad\qquad\qquad (4)$$

Le rendement est donc amélioré par rapport à un circuit du type de celui de la figure 3.

En ce qui concerne le bruit du convertisseur qui est fonction de la variation de charge dQ injectée dans le filtre de sortie $R_b$, $C_b$ de la chaîne de conversion, il est sensiblement nul. Pour un convertisseur classique, la charge Q injectée est donnée par la relation suivante :

$$Q = (I_{ref} + dI_{ref}) \times (T + dT) \qquad\qquad (5)$$

où T représente le temps de charge de la capacité $C_b$ du filtre en sortie du convertisseur.

La variation de charge dQ est donc donnée par la relation suivante :

$$dQ = dI_{ref} \times T + I_{ref} \times dT \qquad\qquad (6)$$

Dans un convertisseur selon l'invention, T est parfaitement maîtrisé et égal à $T_{on}$, donc dT = 0. Le bruit restant est seulement dû au bruit en courant $dI_{ref}$.

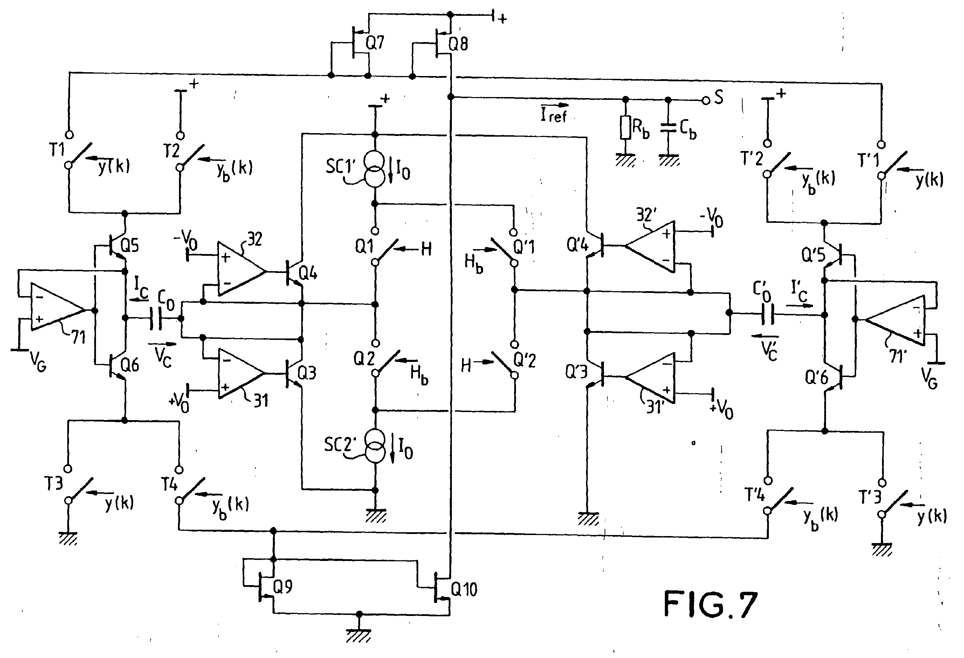

La figure 7 présente un autre mode de réalisation possible d'un convertisseur selon l'invention. Dans ce mode de réalisation, on envoie directement le courant de charge et décharge de la capacité de clamp $C_0$ dans la charge de sortie, c'est-à-dire dans le filtre de sortie $R_b C_b$, au moyen d'interrupteurs et de miroirs de courant. On utilise alors deux circuits de contrôle du type de celui de la figure 5 câblés en différentiel, solution dite à double clamp différentiel, avec deux capacités de clamp que l'on charge et décharge. Pendant que l'une des capacités se charge, l'autre se décharge. Un avantage de ce mode de réalisation est qu'il permet de s'affranchir du bruit en courant $dI_{ref}$ du convertisseur.

Le circuit de contrôle de temps de charge de courant comporte donc une paire de circuits différentielle. Plus particulièrement il comporte deux branches en parallèle comportant chacune une capacité et un circuit de charge et décharge de cette capacité sous courant constant, du type de celui de la figure 5, mais commandés en opposition de phase. Les sources de courant SC1', SC2' sont par exemple communes aux deux circuits. Ainsi, le premier circuit étant identique à celui de la figure 5, le deuxième circuit comporte, en série avec la première source de courant SC1' un premier interrupteur Q1'. Un deuxième interrupteur Q2' est en série avec la deuxième source de courant SC2'. Les interrupteurs sont par exemple des transistors bipolaires ou des transistors de type MOS. Le premier interrupteur Q1' est commandé par le signal d'horloge conjugué $H_b$ alors que l'interrupteur Q1 est commandé par le signal d'horloge H. De même, le deuxième interrupteur Q2' est commandé par le signal d'horloge H alors que l'interrupteur Q2 est commandé par le signal d'horloge $H_b$. Dans ce sens, les deux circuits de la paire différentielle sont commandés en opposition de phase à partir du signal d'horloge H. Une capacité $C'_0$ est connectée entre le point de jonction des deux interrupteurs Q1', Q2'. Cette capacité $C'_0$ est par exemple en valeur égale à la capacité $C_0$ du premier circuit.

Deux circuits limitent l'un cette la tension Vc aux bornes de la capacité $C'_0$ à la valeur maximum $V_0$ et à la valeur minimum $-V_0$. Le circuit de limitation à $V_0$ est par exemple constitué d'un amplificateur opérationnel 31' et d'un transistor bipolaire PNP Q3'. L'entrée positive de l'amplificateur opérationnel 31' reçoit la tension $V_0$ et son entrée négative est reliée à l'émetteur du transistor Q3' lequel est par ailleurs relié au point de jonction des deux interrupteurs Q1', Q2'. La sortie de l'amplificateur opérationnel commande la base du transistor Q3', dont la source est reliée à la deuxième borne d'alimentation, par exemple le potentiel de masse. Lorsque la tension V'c aux bornes du condensateur $C'_0$, qui est aussi la tension présente sur l'entrée négative de l'amplificateur opérationnel atteint la valeur $V_0$ la sortie de l'amplificateur fournit un courant de base au transistor Q3' qui dérive alors le courant $I_0$ que continue à fournir la première source SC1' via l'interrupteur Q1' pendant le reste du temps où l'horloge $H_b$ est à l'état 1. Le circuit de limitation à $-V_0$ est par exemple constitué d'un amplificateur opérationnel 32' et d'un transistor bipolaire NPN Q4'. L'entrée positive de l'amplificateur opérationnel 32' reçoit la tension $-V_0$ et son entrée négative est reliée à l'émetteur du transistor Q4' lequel est par ailleurs relié au point de jonction des deux interrupteurs Q1', Q2'. La sortie de l'amplificateur opérationnel commande la base du transistor Q4', dont la source est reliée à la première borne d'alimentation, positive. Lorsque la tension V'c aux bornes du condensateur $C'_0$, qui est aussi la tension présente sur l'entrée négative de l'amplificateur opérationnel atteint la valeur $-V_0$ la sortie de l'amplificateur fournit un courant de base au transistor Q4' qui dérive alors le courant $I_0$ que continue à fournir la deuxième source SC2' via l'interrupteur Q2' pendant le reste du temps où l'horloge $H_b$ est à l'état 0.

Les deux capacités de clamp $C_0$, $C'_0$ sont reliées chacune à un potentiel de masse virtuel. En d'autres termes, la borne de la capacité $C_0$ ou $C'_0$ non reliée au point de jonction des interrupteurs Q1, Q2 ou Q1', Q2' est reliée à un potentiel asservi à la valeur 0 volt. La fonction de ce potentiel asservi sera expliquée plus loin dans la description.

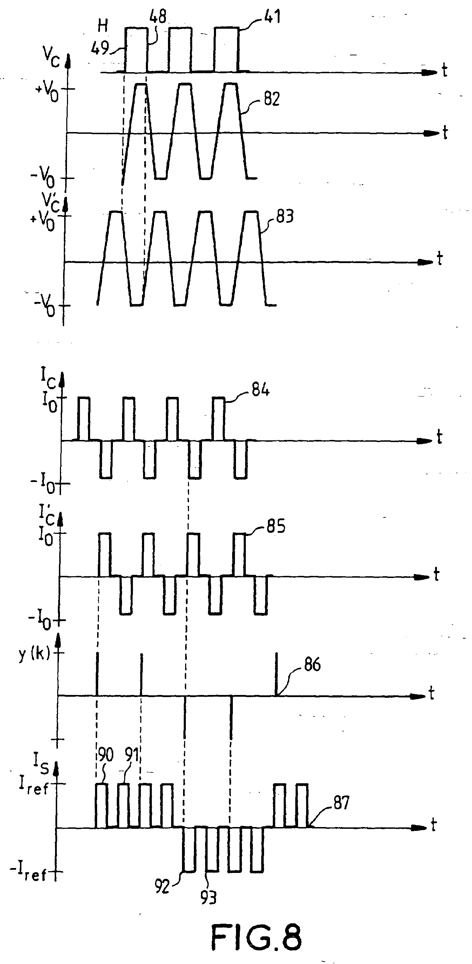

Etant donné que les deux circuits de la paire différentielle sont commandés en opposition de phase comme indiqué précédemment, lorsque la capacité $C_0$ du premier circuit se charge, la capacité $C'_0$ du deuxième circuit se décharge. La figure 8 illustre cette situation. Comme les figures 4 et 6, cette figure illustre différents signaux en jeu en fonction du temps t et en fonction du signal d'horloge H. Une première courbe 41 illustre toujours l'allure du signal d'horloge H en fonction du temps t. Une deuxième courbe 82 illustre l'allure de la tension Vc aux bornes de la capacité $C_0$ et une troisième courbe illustre l'allure de la tension V'c aux bornes de la capacité $C'_0$. Alors que la capacité $C_0$ se charge à partir du front montant 49 du signal d'horloge, la capacité $C'_0$ se décharge. La situation est inverse à partir du front descendant 48 du signal d'horloge H.

Une quatrième courbe 84 illustre le courant Ic dans la capacité $C_0$ et une cinquième courbe 85 illustre le courant I'c dans la capacité $C'_0$. Les deux courants sont en opposition de phase. Lorsque la capacité $C_0$ se charge son courant Ic est égal à $I_0$ et le courant I'c qui passe dans la capacité $C'_0$ qui se décharge alors est $-I_0$, et vice-versa. Le courant Ic correspond au courant Ic de la figure 6, c'est-à-dire au courant de charge de la capacité $C_0$ de la figure 5.

Le filtre de sortie $R_b C_b$ est toujours alimenté par le courant $I_{ref}$, la sortie S du filtre étant la sortie de la chaîne de conversion, en pratique la sortie du convertisseur numérique-analogique. Dans l'exemple de réalisation illustré par la figure 7, le courant de sortie $I_{ref}$ est le courant de charge et décharge des capacités $C_0$, $C'_0$. La durée de charge du filtre par le courant $I_{ref}$, ou $-I_{ref}$ est donc parfaitement définie par le contrôle de la durée de charge des capacités $C_0$, $C'_0$. Le courant de charge et décharge des capacités est par exemple envoyé sur le filtre de sortie au moyen d'interrupteurs et de miroirs de courants, en passant par le point de potentiel asservi à une masse virtuelle.

Le circuit pour ramener le potentiel à 0 comporte par exemple un amplificateur opérationnel 71, 71' dont la borne positive est reliée à un potentiel $V_G$ égal à 0 volt et dont la borne négative, qui constitue le potentiel asservi, est reliée à la borne de la capacité $C_0$, $C'_0$.

Du côté du premier circuit de contrôle, un transistor bipolaire NPN Q5 relie la borne de la capacité $C_0$ à une première paire d'interrupteurs T1, T2. Le collecteur du transistor Q5 est ainsi connecté au point de jonction des deux interrupteurs, l'autre borne de l'interrupteur T1 étant reliée à un premier miroir de courant et l'autre borne l'interrupteur T2 étant reliée à une borne d'alimentation positive. L'émetteur du transistor Q5 est relié à la capacité $C_0$. La base du transistor Q5 est commandée par la sortie de l'amplificateur opérationnel 71.

De même, un transistor PNP Q6 relie la borne de la capacité $C_0$ à une deuxième paire d'interrupteurs T3, T4. Le collecteur du transistor Q6 est ainsi connecté au point de jonction des deux interrupteurs, l'autre borne de l'interrupteur T3 relié au potentiel de masse et l'autre borne l'interrupteur T2 étant reliée à un deuxième miroir de courant. L'émetteur du transistor Q6 est relié à la capacité $C_0$. La base du transistor Q6, comme celle du transistor Q5, est commandée par la sortie de l'amplificateur opérationnel 71.

Les deux paires d'interrupteurs sont commandées par le signal binaire y(k) et son conjugué $y_b(k)$. L'interrupteur T1 est commandé à l'état passant lorsque le signal y(k) est à 1, l'interrupteur T2 est commandé à l'état passant lorsque le signal $y_b(k)$ est à 1, l'interrupteur T3 est commandé à l'état passant lorsque le signal y(k) est à 1 et l'interrupteur T4 est commandé à l'état passant lorsque le signal $y_b(k)$ est à 1.

Du côté du deuxième circuit de contrôle, un transistor bipolaire NPN Q5' relie la borne de la capacité $C_0'$ à une première paire d'interrupteurs T1',T2'. Le collecteur du transistor Q5' est ainsi connecté au point de jonction des deux interrupteurs, l'autre borne de l'interrupteur T1' étant reliée au premier miroir de courant et l'autre borne l'interrupteur T2' étant reliée à une borne d'alimentation positive. L'émetteur du transistor Q5' est relié à la capacité $C_0'$. La base du transistor Q5' est commandée par la sortie de l'amplificateur opérationnel 71'.

Un transistor PNP Q6' relie la borne de la capacité $C_0$, à une deuxième paire d'interrupteurs T3', T4'. Le collecteur du transistor Q6' est ainsi connecté au point de jonction des deux interrupteurs, l'autre borne de l'interrupteur T3' relié au potentiel de masse et l'autre borne l'interrupteur T2' étant reliée au deuxième miroir de courant. L'émetteur du transistor Q6' est relié à la capacité $C_0'$. La base du transistor Q6', comme celle du transistor Q5', est commandée par la sortie de l'amplificateur opérationnel 71'.

Le premier miroir de courant comporte par exemple deux transistors PMOS dont la grille est reliée aux interrupteurs T1, T1' et dont la source est reliée à la borne d'alimentation positive. Le drain d'un des deux transistors Q7 est relié aux interrupteurs T1, T1'. Le deuxième miroir de courant comporte par exemple deux transistors NMOS dont la grille est reliée aux interrupteurs T3, T3' et dont la source est reliée au potentiel de masse. Le drain d'un des deux transistors Q9 est relié aux interrupteurs T3, T3'. Le drain de l'autre transistor Q10 est relié au drain du transistor Q8 du premier miroir de courant. Le point de jonction de ces deux transistors Q8, Q10 est relié à l'entrée du filtre de sortie $R_b$, $C_b$. Ce dernier est donc chargé par la sortie des drains des transistors Q8, Q10, c'est-à-dire par la sortie du miroir de courant.

Les deux paires d'interrupteurs sont commandées par le signal binaire y(k) et son conjugué $y_b(k)$, et de la même façon.

Lorsque la capacité $C_0$ se charge sous le courant $I_0$, ce courant passe dans le transistor Q6. Le transistor Q5 est alors bloqué par la tension Vbe de ce dernier. De même, le transistor Q5' est passant et le transistor Q6' est bloqué, car la capacité $C'_0$ se décharge. Deux cas alors peuvent se présenter selon que le signal y(k) est à l'état 1 ou à l'état 0.

Si ce signal y(k) est à 1, le courant Ic passant par le transistor Q6 est aiguillé par l'interrupteur T3 vers le potentiel de masse et le courant I'c passant par le transistor Q5' est aiguillé par le transistor T1' depuis les transistors Q7, Q8 du premier miroir de courant. Les deux transistors Q7, Q8 commandés avec la même tension grille-source conduisent alors le même courant. A cet effet, le potentiel de masse virtuel $V_G$ permet le passage du courant de charge Ic dans le miroir de courant. Le courant Ic étant imposé au transistor Q7, le transistor Q8 conduit aussi ce courant. Le courant fourni par ce transistor Q8 est le courant $I_{ref}$ fourni au filtre de sortie. Il est positif et par exemple de valeur $I_0$.

Si le signal y(k) est à 0, le courant Ic passant par le transistor Q6 est aiguillé par le transistor T4 vers le deuxième miroir de courant alors que le courant I'c qui passe dans le transistor Q5' est aiguillé depuis l'alimentation positive. Les deux transistors Q9, Q10 du miroir de courant commandés par la même tension grille-source conduisent le même courant de valeur $I_0$. Le filtre de sortie est alors déchargé par ce courant qui passe dans le drain du transistor Q10. Dans ce cas le courant de charge du filtre d'entrée $I_{ref}$ est négatif, par exemple de valeur-$I_0$.

Lorsque la capacité $C_0$ se décharge sous le courant $I_0$, ce courant passe dans le transistor Q5. Le transistor Q6 est alors bloqué par la tension Vbe de ce dernier. De même, le transistor Q6' est passant et le transistor Q5' est bloqué, car la capacité $C'_0$ se charge. Les mêmes deux cas que précédemment peuvent donc se présenter.

Si le signal y(k) est à 1, le courant I'c passant par le transistor Q6' est aiguillé par l'interrupteur T3' vers le potentiel de masse et le courant Ic passant par le transistor Q5 est aiguillé par le transistor T1 depuis les transistors Q7, Q8 du premier miroir de courant. Les deux transistors Q7, Q8 commandés avec la même tension grille-source conduisent alors le même courant. Le courant Ic étant imposé au transistor Q7, le transistor Q8 conduit aussi ce courant. Le courant fourni par ce transistor Q8 est le courant $I_{ref}$ fourni au filtre de sortie. Il est positif et par exemple de valeur $I_0$.

Si le signal y(k) est à 0, le courant Ic passant par le transistor Q6' est aiguillé par le transistor T4' vers le deuxième miroir de courant alors que le courant Ic qui passe dans le transistor Q5 est aiguillé depuis l'alimentation positive. Les deux transistors Q9, Q10 du miroir de courant commandés par la même tension grille-source conduisent le même courant de valeur $I_0$. Le filtre de sortie est alors déchargé par ce courant qui passe dans le drain du transistor Q10. Dans ce cas le courant de charge du filtre d'entrée $I_{ref}$ est négatif, par exemple de valeur -$I_0$.

Ainsi, lorsque le bit y(k) est à 1, le courant $I_{ref}$ charge le filtre d'entrée, que les capacités $C_0$, $C'_0$ se chargent ou se déchargent. De même, lorsque le bit y(k) est à 0, le courant dans le filtre de sortie est -$I_{ref}$. La durée de charge du courant $I_{ref}$ ou -$I_{ref}$ dans le filtre est parfaitement contrôlée par la durée de charge ou décharge des capacités $C_0$, $C'_0$.

Les deux dernières courbes 86, 87 de la figure 8 illustrent ce résultat. Une courbe 86 donne un exemple d'une suite de valeurs y(k) et une courbe 87 donne le courant Is en sortie du filtre de sortie du convertisseur en fonction des bits y(k). Le temps de contrôle des charges et décharges des capacités $C_0$, $C'_0$ sont tels qu'il y ait par exemple au moins une charge de la capacité $C_0$ et une décharge de la capacité $C'_0$ entre deux l'arrivée de deux bits successifs y(k) en entrée du convertisseur. Lorsqu'un bit y(k) est à 1, il y a alors deux impulsions successives positives de courant 90, 91 sur le filtre de sortie. Ces deux impulsions correspondent pour la première au courant I'c de charge de la capacité $C'_0$ et pour la deuxième au courant Ic de charge de la capacité $C_0$. Lorsque le bit y(k) est à l'état 0, il y a alors deux impulsions successives négatives de courant 92, 93 sur le filtre de sortie. Ces deux correspondent pour la première au courant Ic de charge de la capacité $C_0$ et pour la deuxième au courant I'c de charge de la capacité $C'_0$.

L'exemple de convertisseur numérique-analogique tel qu'illustré par la figure 7 a l'avantage notamment d'avoir un bon rendement comme celui illustré par la figure 5, pour les mêmes raisons. Il permet en plus de s'affranchir du bruit des sources de courant $dI_{ref}$. Ce bruit de courant induit un bruit de charge électrique correspondant dQ qui est donné par la relation suivante :

$$dQ = dI_{ref}T_{on} = \frac{2dI_{ref}C_0V_0}{I_0} \qquad (7)$$

selon la relation (3), pour la durée $T_{on}$ de deux impulsions. Pour la durée d'une impulsion de courant $I_{ref}$, le bruit est donné par :

$$dQ = \frac{dI_{ref}C_0V_0}{I_0} \qquad (8)$$

Par ailleurs, la charge électrique Q envoyée au filtre de sortie pendant une impulsion est parfaitement contrôlée par la tension dite de clamp $V_0$ et par la capacité dite de clamp $C_0$, elle vaut comme il est bien connu $C_0V_0$. Il s'ensuit donc que dQ est nul. En fait, étant donné que $dI_{ref}$ existe et que sa valeur n'est pas nulle, le temps $T_{on}$, ou $T_{on}/2$ pendant lequel on envoie le courant s'ajuste en fonction du bruit de courant $I_0$, puisque ce temps $T_{on}$ est justement fonction de $I_0$ comme l'a rappelé précédemment la relation (3).

En fait :

$$\frac{dV_0}{dt} = \frac{(I_0 + Ib_0)}{C_0} \tag{9}$$

où $Ib_0$ est le bruit en courant superposé à $I_0$.
$T_{on}$ s'ajuste de façon à ce que :

$$V_0 = \int_0^{T_{on}} \frac{(I_0 + Ib_0)}{C_0} dt \tag{10}$$

grâce au circuit de clamp.
Etant donné que

$$Q = 2 \int_0^{T_{on}} (I_0 + Ib_0) dt \tag{11}$$

il s'ensuit que $Q = 2C_0V_0$ et donc que $dQ=0$.
Les interrupteurs peuvent être des transistors bipolaires ou de type MOS. De même les autres transistors utilisés dans le circuit de contrôle du temps d'établissement du courant peuvent être bipolaires ou de type MOS. Ces transistors sont NPN, PNP, NMOS, PMOS selon les polarités en jeu conformément aux connaissances de l'homme du métier.

## Revendications

1.  Convertisseur numérique-analogique en courant, recevant en entrée une succession de bits (y(k)) d'un signal binaire et délivrant en sortie, échantillonné par un signal d'horloge (H), un courant positif ($+I_{ref}$) ou négatif ($-I_{ref}$) selon l'état du bit d'entrée, **caractérisé en ce qu'**il comporte au moins un circuit de contrôle de la durée (Tc) des impulsions (53) de courant de sortie ($+I_{ref}$, $-I_{ref}$) du convertisseur comportant une capacité ($C_0$) et un circuit de charge de cette capacité commandé par le signal d'horloge, la durée (Tc) des impulsions (53) étant contrôlée par la charge de ladite capacité ($C_0$, $C'_0$) par un courant constant ($+I_0$, $-I_0$) jusqu'à une tension de référence ($+V_0$, $-V_0$).

2.  Convertisseur selon la revendication 1, **caractérisé en ce que** le circuit de contrôle comporte au moins :

    - un interrupteur Q1 commandé par le signal d'horloge (H) de telle sorte que Q1 soit passant lorsque le signal d'horloge est à l'état 1 et bloqué lorsque le signal d'horloge est à l'état 0, l'interrupteur Q1 étant connecté entre une borne d'alimentation positive et une borne d'une source de courant SC1' qui fournit le courant constant ($+I_0$, $-I_0$), l'autre borne de cette source étant reliée à une autre borne d'alimentation ;
    - la capacité $C_0$, connectée au point de jonction de l'interrupteur Q1 et de la source de courant SC1', le courant ($+I_0$, $-I_0$) passant dans l'interrupteur Q1 lorsque ce dernier est ouvert et chargeant la capacité $C_0$ lorsque l'interrupteur Q1 est fermé ;
    - un amplificateur opérationnel (32) dont l'entrée positive est reliée au potentiel de référence ($V_0$, $-V_0$) et dont l'entrée négative est reliée à l'émetteur d'un transistor Q4, cet émetteur étant relié au point de jonction de la source de courant, de la capacité $C_0$ et de l'interrupteur Q1, la base du transistor Q4 étant commandée par la sortie de l'amplificateur opérationnel (32) et son collecteur étant relié à la borne d'alimentation positive ;

    lorsque la tension (Vc) aux bornes de la capacité ($C_0$) atteint la valeur de référence ($-V_0$), la sortie de l'amplificateur opérationnel (32) commande le transistor Q4 à l'état passant de telle sorte que le courant ($I_0$) soit dévié par Q4, la capacité restant alors chargée à la tension de référence ($-V_0$).

**3.** Convertisseur selon la revendication 1, **caractérisé en ce que** le circuit de contrôle du temps d'établissement du courant de sortie ($+I_{ref}$, $-I_{ref}$) comporte au moins un circuit de charge et décharge de la capacité à courant constant ($I_0$) commandé par le signal d'horloge (H) utilisant deux tensions de référence ($+V_0$, $-V_0$), la capacité ($C_0$, $C'_0$) étant chargée puis déchargée entre ces deux tensions, le temps d'établissement ($T_{on}$) du courant de sortie étant alors la somme du temps mis pour charger la capacité et du temps mis pour décharger la capacité.

**4.** Convertisseur selon la revendication 3, **caractérisé en ce que** le circuit de charge et décharge de la capacité du circuit de contrôle comporte :

- en série une première source de courant SC1' délivrant un courant constant ($I_0$) connectée à une borne d'alimentation, un premier interrupteur Q1, un deuxième interrupteur Q2 et une deuxième source de courant SC2' délivrant un courant constant ($I_0$) reliée à une deuxième borne d'alimentation, le premier interrupteur Q1 étant commandé par le signal d'horloge (H) et le deuxième interrupteur Q2 étant commandé par le conjugué du signal d'horloge ($H_b$), la capacité $C_0$ étant connectée entre le point de jonction des deux interrupteurs Q1, Q2 chargée et déchargée par le courant constant ($I_0$) ;
- deux circuits limitant la tension (Vc) aux bornes de la capacité ($C_0$), l'un à une première tension de référence ($V_0$) et l'autre à une deuxième tension de référence ($-V_0$), le circuit de limitation à la première tension de référence ($V_0$) comportant un premier amplificateur opérationnel (31) et un transistor bipolaire Q3, l'entrée positive de l'amplificateur opérationnel (31) recevant la première tension de référence ($V_0$) et son entrée négative étant reliée à l'émetteur du transistor Q3 lequel est relié au point de jonction des deux interrupteurs Q1, Q2, la sortie de l'amplificateur opérationnel commandant la base du transistor Q3, dont la source est reliée à la deuxième borne d'alimentation, le circuit de limitation à la deuxième tension de référence ($-V_0$) comportant un amplificateur opérationnel (32) et un transistor Q4, l'entrée positive de l'amplificateur opérationnel (32) recevant la deuxième tension de référence (-Vo) et son entrée négative étant reliée à l'émetteur du transistor Q4 lequel est relié au point de jonction des deux interrupteurs Q1, Q2, la sortie de l'amplificateur opérationnel commandant la base du transistor Q4, dont le collecteur est relié à la première borne d'alimentation, le premier amplificateur (31) commandant le transistor Q3 qui dérive alors le courant $I_0$ fourni par la première source SC1' lorsque la tension (Vc) aux bornes du condensateur ($C_0$) atteint la première tension de référence ($V_0$) et le deuxième amplificateur (32) commandant le transistor Q4 qui dérive alors le courant $I_0$ fourni par la deuxième source SC2' lorsque la tension (Vc) aux borne de la capacité ($C_0$) atteint la deuxième tension de référence ($-V_0$).

**5.** Convertisseur selon l'une quelconque des revendications 3 ou 4, **caractérisé en ce qu'**il comporte en parallèle deux branche comportant chacune :

- un circuit de charge et décharge d'une capacité ($C_0$, $C'_0$) sous un courant constant ($I_0$) à deux tensions de référence ($V_0$, $-V_0$) ;
- une capacité ($C_0$) connectée entre le point de jonction des interrupteurs de la première branche et l'émetteur d'un transistor Q5 relié au collecteur d'un transistor Q6 ;
- un amplificateur opérationnel (71) dont l'entrée positive est reliée à un potentiel donné ($V_G$) et dont l'entrée négative est reliée au point de jonction des transistors et de la capacité, la sortie de l'amplificateur commandant les transistors ;
- un premier miroir et un deuxième miroir de courant ayant une sortie commune, cette sortie commune étant la sortie du convertisseur, la sortie du premier miroir délivrant un courant positif et la sortie du deuxième convertisseur délivrant un courant négatif ;
- une première paire d'interrupteurs T1, T2 ayant un point de jonction commun relié au transistor Q5, l'interrupteur T1 étant relié par son autre borne au premier miroir de courant (Q7,Q8) et l'interrupteur T2 étant relié par son autre borne à une borne d'alimentation, les interrupteurs étant commandés par le bit d'entrée y(k) de sorte que T1 soit passant lorsque le bit est à l'état 1 et que T2 soit passant lorsque le bit est à l'état 0, le courant de décharge ($I_0$) de la capacité ($C_0$) passant du premier transistor Q7 du miroir de courant à la capacité, via l'interrupteur T1 et le transistor Q5 lorsque la capacité se décharge, ce courant ($I_0$) étant alors présent en sortie du premier miroir et du convertisseur ;
- une deuxième paire d'interrupteurs T3, T4 ayant un point de jonction commun relié au transistor Q6, l'interrupteur T4 étant relié par son autre borne au deuxième miroir de courant (Q9,Q10) et l'interrupteur T3 étant relié par son autre borne à une borne de masse, les interrupteurs étant commandés par le bit d'entrée y(k) de sorte que T3 soit passant lorsque le bit est à l'état 1 et que T4 soit passant lorsque le bit est à l'état 0, le courant de charge ($I_0$) de la capacité ($C_0$) passant du premier transistor Q9 du miroir de courant à la capacité, via l'interrupteur T4 et le transistor Q6 lorsque la capacité se charge, ce courant ($I_0$) étant alors présent en sortie du deuxième miroir et du convertisseur ;

les deux branches étant commandées en opposition de phase par le signal d'horloge (H), une capacité ($C_0$) se chargeant pendant que l'autre ($C'_0$) se décharge.

6. Convertisseur selon la revendication 5, **caractérisé en ce que** les circuits de charge et décharge du courant des capacités ($C_0$, $C'_0$) ont les mêmes sources de courant (SC1', SC2').

7. Convertisseur selon l'une quelconque des revendications précédentes, **caractérisé en ce que** le courant de sortie du convertisseur charge un filtre ($R_b$, $C_b$).

8. Convertisseur selon l'une quelconque des revendications précédentes, **caractérisé en ce que** le bit d'entrée du convertisseur y(k) est fourni par un convertisseur sigma-delta.

**Claims**

1. Current type digital/analogue converter, receiving as input a succession of bits (y(k)) of a binary signal and delivering as output, sampled by a clock signal (H), a positive current ($+I_{ref}$) or negative current ($-I_{ref}$) depending on the state of the input bit, **characterized in that** it comprises at least one circuit for driving the duration (Tc) of the output current ($+I_{ref}$, $-I_{ref}$) pulses (53) of the converter comprising a capacitor ($C_0$) and a circuit for charging this capacitor, controlled by the clock signal, the duration (Tc) of the pulses (53) being driven by the charging of the said capacitor ($C_0$, $C'_0$) by a constant current ($+I_0$, $-I_0$) up to a reference voltage ($+V_0$, $-V_0$).

2. Converter according to Claim 1, **characterized in that** the drive circuit comprises at least:

   - a switch Q1 controlled by the clock signal (H) in such a way that Q1 is on when the clock signal is in the 1 state and off when the clock signal is in the 0 state, the switch Q1 being connected between a positive supply terminal and a terminal of a current source SC1' which provides the constant current ($+I_0$, $-I_0$), the other terminal of this source being linked to another supply terminal;
   - the capacitor $C_0$, connected to the junction point of the switch Q1 and of the current source SC1', the current ($+I_0$, $-I_0$) passing through the switch Q1 when the latter is open and charging the capacitor $C_0$ when the switch Q1 is closed;
   - an operational amplifier (32) whose positive input is linked to the reference potential ($V_0$, $-V_0$) and whose negative input is linked to the emitter of a transistor Q4, this emitter being linked to the junction point of the current source, of the capacitor $C_0$ and of the switch Q1, the base of the transistor Q4 being controlled by the output of the operational amplifier (32) and its collector being linked to the positive supply terminal;

   when the voltage (Vc) across the terminals of the capacitor ($C_0$) reaches the reference value ($-V_0$), the output of the operational amplifier (32) controls the transistor Q4 to the passing state so that the current ($I_0$) is diverted by Q4, the capacitor then remaining charged to the reference voltage ($-V_0$).

3. Converter according to Claim 1, **characterized in that** the circuit for driving the setup time for the output current ($+I_{ref}$, $-I_{ref}$) comprises at least one circuit for charging and discharging the capacitor at constant current ($I_0$) controlled by the clock signal (H) using two reference voltages ($+V_0$, $-V_0$), the capacitor ($C_0$, $C'_0$) being charged then discharged between these two voltages, the setup time ($T_{on}$) of the output current then being the sum of the time taken to charge the capacitor and of the time taken to discharge the capacitor.

4. Converter according to Claim 3, **characterized in that** the circuit for charging and discharging the capacitor of the drive circuit comprises:

   - in series a first current source SC1' delivering a constant current ($I_0$) connected to a supply terminal, a first switch Q1, a second switch Q2 and a second current source SC2' delivering a constant current ($I_0$) linked to a second supply terminal, the first switch Q1 being controlled by the clock signal (H) and the second switch Q2 being controlled by the conjugate of the clock signal ($H_b$), the capacitor $C_0$ being connected between the junction point of the two switches Q1, Q2 charged and discharged by the constant current ($I_0$);
   - two circuits limiting the voltage (Vc) across the terminals of the capacitor ($C_0$), one to a first reference voltage ($V_0$) and the other to a second reference voltage ($-V_0$), the circuit for limiting to the first reference voltage ($V_0$)

comprising a first operational amplifier (31) and a bipolar transistor Q3, the positive input of the operational amplifier (31) receiving the first reference voltage ($V_0$) and its negative input being linked to the emitter of the transistor Q3 which is linked to the junction point of the two switches Q1, Q2, the output of the operational amplifier controlling the base of the transistor Q3, whose source is linked to the second supply terminal, the circuit for limiting to the second reference voltage ($-V_0$) comprising an operational amplifier (32) and a transistor Q4, the positive input of the operational amplifier (32) receiving the second reference voltage ($-V_0$) and its negative input being linked to the emitter of the transistor Q4 which is linked to the junction point of the two switches Q1, Q2, the output of the operational amplifier controlling the base of the transistor Q4, whose collector is linked to the first supply terminal,

the first amplifier (31) controlling the transistor Q3 which then diverts the current $I_0$ provided by the first source SC1' when the voltage (Vc) across the terminals of the capacitor ($C_0$) reaches the first reference voltage ($V_0$) and the second amplifier (32) controlling the transistor Q4 which then diverts the current $I_0$ provided by the second source SC2' when the voltage (Vc) across the terminals of the capacitor ($C_0$) reaches the second reference voltage ($-V_0$).

5. Converter according to either one of Claims 3 or 4, **characterized in that** it comprises in parallel two branches each comprising:

- a circuit for charging and discharging a capacitor ($C_0$, $C'_0$) under a constant current ($I_0$) to two reference voltages ($V_0$, $-V_0$) ;
- a capacitor ($C_0$) connected between the junction point of the switches of the first branch and the emitter of a transistor Q5 linked to the collector of a transistor Q6;
- an operational amplifier (71) whose positive input is linked to a given potential ($V_G$) and whose negative input is linked to the junction point of the transistors and of the capacitor, the output of the amplifier controlling the transistors;
- a first mirror and a second current mirror having a common output, this common output being the output of the converter, the output of the first mirror delivering a positive current and the output of the second converter delivering a negative current;
- a first pair of switches T1, T2 having a common junction point linked to the transistor Q5, the switch T1 being linked by its other terminal to the first current mirror (Q7, Q8) and the switch T2 being linked by its other terminal to a supply terminal, the switches being controlled by the input bit y(k) in such a way that T1 is on when the bit is in the 1 state and that T2 is on when the bit is in the 0 state, the discharge current ($I_0$) of the capacitor ($C_0$) passing from the first transistor Q7 of the current mirror to the capacitor, via the switch T1 and the transistor Q5 when the capacitor discharges, this current ($I_0$) then being present at the output of the first mirror and of the converter;
- a second pair of switches T3, T4 having a common junction point linked to the transistor Q6, the switch T4 being linked by its other terminal to the second current mirror (Q9, Q10) and the switch T3 being linked by its other terminal to an earth terminal, the switches being controlled by the input bit y(k) in such a way that T3 is on when the bit is in the 1 state and that T4 is on when the bit is in the 0 state, the charging current ($I_0$) of the capacitor ($C_0$) passing from the first transistor Q9 of the current mirror to the capacitor, via the switch T4 and the transistor Q6 when the capacitor charges, this current ($I_0$) then being present at the output of the second mirror and of the converter;
- the two branches being controlled in phase opposition by the clock signal (H), a capacitor ($C_0$) charging while the other ($C'_0$) discharges.

6. Converter according to Claim 5, **characterized in that** the circuits for charging and discharging the current of the capacitors ($C_0$, $C'_0$) have the same current sources (SC1', SC2').

7. Converter according to any one of the preceding claims, **characterized in that** the output current of the converter charges a filter ($R_b$, $C_b$).

8. Converter according to any one of the preceding claims, **characterized in that** the input bit of the converter y(k) is provided by a sigma-delta converter.

**Patentansprüche**

1. Digital-Analog-Wandler vom Stromtyp, der am Eingang eine Folge von Bits (y(k)) eines Binärsignals empfängt und am Ausgang je nach dem Zustand des Eingangsbits einen von einem Taktsignal (H) getasteten positiven ($+I_{ref}$) oder negativen Strom ($-I_{ref}$) liefert, **dadurch gekennzeichnet, dass** er mindestens einen Prüfstromkreis der Dauer ($T_c$) der Impulse (53) des Ausgangsstroms ($+I_{ref}$, $-I_{ref}$) des Wandlers aufweist, der einen Kondensator ($C_0$) und eine Ladeschaltung dieses Kondensators aufweist, die vom Taktsignal gesteuert wird, wobei die Dauer ($T_c$) der Impulse (53) durch die Ladung des Kondensators ($C_0$, $C'_0$) mit einem Gleichstrom ($+I_0$, $-I_0$) bis zu einer Bezugsspannung ($+V_0$, $-V_0$) geprüft wird.

2. Wandler nach Anspruch 1, **dadurch gekennzeichnet, dass** der Prüfstromkreis mindestens aufweist:

  - einen Unterbrecher Q1, der vom Taktsignal (H) derart gesteuert wird, dass Q1 leitend ist, wenn das Taktsignal im Zustand 1 ist, und gesperrt ist, wenn das Taktsignal im Zustand 0 ist, wobei der Unterbrecher Q1 zwischen einer positiven Versorgungsklemme und einer Klemme einer Stromquelle SC1' angeschlossen ist, die den Gleichstrom ($+I_0$, $-I_0$) liefert, wobei die andere Klemme dieser Quelle mit einer anderen Versorgungsklemme verbunden ist;
  - den Kondensator $C_0$, der mit dem Verbindungspunkt zwischen dem Unterbrecher Q1 und der Stromquelle SC1' verbunden ist, wobei der Strom ($+I_0$, $-I_0$) in den Unterbrecher Q1 übergeht, wenn letzterer offen ist, und den Kondensator $C_0$ lädt, wenn der Unterbrecher Q1 geschlossen ist;
  - einen Operationsverstärker (32), dessen positiver Eingang mit dem Bezugspotential ($V_0$,
  - $V_0$), und dessen negativer Eingang mit dem Emitter eines Transistors Q4 verbunden ist,

  wobei dieser Emitter mit dem Verbindungspunkt zwischen der Stromquelle, dem Kondensator $C_0$ und dem Unterbrecher Q1 verbunden ist, wobei die Basis des Transistors Q4 vom Ausgang des Operationsverstärkers (32) gesteuert wird und sein Kollektor mit der positiven Versorgungsklemme verbunden ist; wenn die Spannung (Vc) an den Klemmen des Kondensators ($C_0$) den Bezugswert ($-V_0$) erreicht, steuert der Ausgang des Operationsverstärkers (32) den Transistor Q4 in den leitenden Zustand, so dass der Strom ($I_0$) von Q4 abgelenkt wird, wobei der Kondensator dann auf der Bezugsspannung ($-V_0$) geladen bleibt.

3. Wandler nach Anspruch 1, **dadurch gekennzeichnet, dass** der Prüfstromkreis der Aufbauzeit des Ausgangsstroms ($+I_{ref}$, $-I_{ref}$) mindestens eine Lade- und Entladeschaltung des Gleichstromkondensators ($I_0$) aufweist, die vom Taktsignal (H) unter Verwendung von zwei Bezugsspannungen ($+V_0$, $-V_0$) gesteuert wird, wobei der Kondensator ($C_0$, $C'_0$) zwischen diesen beiden Spannungen geladen und dann entladen wird, wobei die Aufbauzeit ($T_{on}$) des Ausgangsstroms dann die Summe der Zeit, die zum Laden des Kondensators benötigt wird, und der Zeit ist, die zum Entladen des Kondensators benötigt wird.

4. Wandler nach Anspruch 3, **dadurch gekennzeichnet, dass** die Lade- und Entladeschaltung des Kondensators des Prüfstromkreises aufweist:

  - in Reihe eine erste einen Gleichstrom ($I_0$) liefernde Stromquelle SC1', die mit einer Versorgungsklemme verbunden ist, einen ersten Unterbrecher Q1, einen zweiten Unterbrecher Q2, und eine zweite einen Gleichstrom ($I_0$) liefernde Stromquelle SC2', die mit einer zweiten Versorgungsklemme verbunden ist, wobei der erste Unterbrecher Q1 vom Taktsignal (H) und der zweite Unterbrecher Q2 von der Konjugierten des Taktsignals ($H_b$) gesteuert wird, wobei der Kondensator $C_0$ zwischen dem Verbindungspunkt der beiden Unterbrechers Q1, Q2 angeschlossen ist und vom Gleichstrom ($I_0$) geladen und entladen wird;
  - zwei Schaltungen, die die Spannung (Vc) an den Klemmen des Kondensators ($C_0$) begrenzen, die eine auf eine erste Bezugsspannung ($V_0$) und die andere auf eine zweite Bezugsspannung ($-V_0$),

  wobei die Schaltung zur Begrenzung auf die erste Bezugsspannung ($V_0$) einen ersten Operationsverstärker (31) und einen bipolaren Transistor Q3 aufweist, wobei der positive Eingang des Operationsverstärkers (31) die erste Bezugsspannung ($V_0$) empfängt und sein negativer Eingang mit dem Emitter des Transistors Q3 verbunden ist, der mit dem Verbindungspunkt der beiden Unterbrecher Q1, Q2 verbunden ist, wobei der Ausgang des Operationsverstärkers die Basis des Transistors Q3 steuert, dessen Source mit der zweiten Versorgungsklemme verbunden ist, wobei die Schaltung zur Begrenzung auf die zweite Bezugsspannung ($-V_0$) einen Operationsverstärker (32) und einen Transistor Q4 aufweist, wobei der positive Eingang des Operationsverstärkers (32) die zweite Bezugsspannung ($-V_0$) empfängt und sein negativer Eingang mit dem Emitter des Transistors Q4 verbunden ist, der mit dem Verbindungspunkt der beiden Schalter Q1, Q2 verbunden ist, wobei der Ausgang des Operationsverstärkers die Basis des Transistors Q4 steuert, dessen Kollektor mit der ersten Versorgungsklemme verbunden ist, wobei der erste Verstärker (31) den Transistor Q3 steuert, der dann den Strom $I_0$ abzweigt, der von der ersten Quelle SC1' geliefert wird, wenn die Spannung (Vc) an den Klemmen des Kondensators ($C_0$) die erste Bezugs-

spannung ($V_0$) erreicht, und der zweite Verstärker (32) den Transistor Q4 steuert, der den von der zweiten Quelle SC2' gelieferten Strom $I_0$ abzweigt, wenn die Spannung (Vc) an den Klemmen des Kondensators ($C_0$) die zweite Bezugsspannung ($-V_0$) erreicht.

5. Wandler nach einem der Ansprüche 3 oder 4, **dadurch gekennzeichnet, dass** er parallel zwei Zweige aufweist, die je enthalten:

> - eine Lade- und Entladeschaltung eines Kondensators ($C_0$, $C'_0$) unter Gleichstrom ($I_0$) mit zwei Bezugsspannungen ($V_0$, $-V_0$) ;
> - einen Kondensator ($C_0$), der zwischen dem Verbindungspunkt der Unterbrecher des ersten Zweigs und dem Emitter eines Transistors Q5 angeschlossen ist, der mit dem Kollektor eines Transistors Q6 verbunden ist;
> - einen Operationsverstärker (71), dessen positiver Eingang mit einem gegebenen Potential ($V_G$) verbunden ist und dessen negativer Eingang mit dem Verbindungspunkt der Transistoren und des Kondensators verbunden ist, wobei der Ausgang des Verstärkers die Transistoren steuert;
> - einen ersten Stromspiegel und einen zweiten Stromspiegel, die einen gemeinsamen Ausgang haben, wobei dieser gemeinsame Ausgang der Ausgang des Wandlers ist, wobei der Ausgang des ersten Spiegels einen positiven Strom und der Ausgang des zweiten Wandlers einen negativen Strom liefert;
> - ein erstes Paar von Unterbrechern T1, T2, deren gemeinsamer Verbindungspunkt mit dem Transistor Q5 verbunden ist, wobei der Unterbrecher T1 über seine andere Klemme mit dem ersten Stromspiegel (Q7, Q8) und der Unterbrecher T2 über seine andere Klemme mit einer Versorgungsklemme verbunden ist, wobei die Unterbrecher vom Eingangsbit y(k) derart gesteuert werden, dass T1 leitend ist, wenn das Bit im Zustand 1 ist, und T2 leitend ist, wenn das Bit im Zustand 0 ist, wobei der Entladestrom ($I_0$) des Kondensators ($C_0$) vom ersten Transistor Q7 des Stromspiegels auf den Kondensator über den Unterbrecher T1 und über den Transistor Q5 übergeht, wenn der Kondensator sich entlädt, wobei dieser Strom ($I_0$) dann am Ausgang des ersten Spiegels und des Wandlers vorhanden ist;
> - ein zweites Paar von Unterbrechern T3, T4, deren gemeinsamer Punkt mit dem Transistor Q6 verbunden ist, wobei der Unterbrecher T4 über seine andere Klemme mit dem zweiten Stromspiegel (Q9, Q10) und der Unterbrecher T3 über seine andere Klemme mit einer Masseklemme verbunden ist, wobei die Unterbrecher vom Eingangsbit y(k) derart gesteuert werden, dass T3 leitend ist, wenn das Bit im Zustand 1 ist, und T4 leitend ist, wenn das Bit im Zustand 0 ist, wobei der Ladestrom ($I_0$) des Kondensators ($C_0$) vom ersten Transistor Q9 des Stromspiegels zum Kondensator über den Unterbrecher T4 und den Transistor Q6 übergeht, wenn der Kondensator sich lädt, wobei dieser Strom ($I_0$) dann am Ausgang des zweiten Spiegels und des Wandlers vorhanden ist;

wobei die beiden Zweige gegenphasig vom Taktsignal (H) gesteuert werden, wobei ein Kondensator ($C_0$) sich lädt, während der andere ($C'_0$) sich entlädt.

6. Wandler nach Anspruch 5, **dadurch gekennzeichnet, dass** die Lade- und Entladeschaltungen des Stroms der Kondensatoren ($C_0$, $C'_0$) die gleichen Stromquellen (SC1', SC2') haben.

7. Wandler nach einem der vorhergehenden Ansprüche, **dadurch gekennzeichnet, dass** der Ausgangsstrom des Wandlers ein Filter ($R_b$, $C_b$) lädt.

8. Wandler nach einem der vorhergehenden Ansprüche, **dadurch gekennzeichnet, dass** das Eingangsbit des Wandlers y(k) von einem Sigma-Delta-Wandler geliefert wird.

# FIG.1

# FIG.2

FIG.3

FIG.4

FIG.5

FIG.6

FIG.7

FIG.8